Europäisches Patentamt

European Patent Office

Office européen des brevets

(11) Publication number: 0 454 151 A1

# EUROPEAN PATENT APPLICATION

(21) Application number: 91106811.2

(22) Date of filing: 26.04.91

(51) Int. Cl.5: **C30B 15/10, C30B 15/14, C30B 29/06**

(30) Priority: 27.04.90 JP 112050/90

(43) Date of publication of application:
30.10.91 Bulletin 91/44

(84) Designated Contracting States:
**DE FR GB**

(71) Applicant: **OSAKA TITANIUM COMPANY LIMITED**
**1, Higashihama-cho Amagasaki**
**Hyogo(JP)**

(72) Inventor: **Kaneko, Kyojiro**
**1-10-206, Shirakawa 3-chome**
**Ibaraki,Osaka(JP)**
Inventor: **Mizumoto, Hideyuki**
**378-14, Oaza-kamimabushi**
**Kadoma, Osaka(JP)**

(74) Representative: **Wächtershäuser, Günter, Dr.**
**Tal 29**
**W-8000 München 2(DE)**

(54) **Manufacturing method of silicon single-crystal.**

(57) A manufacturing method for single-crystal silicon, characterized in that a melt reservoir uses induction coils (41) coated inside with high-melting insulating material (43) and adapted to apply an electromagnetic field to silicon placed in said melt reservoir to heat and melt said silicon (60), so that a single-crystal silicon rod (62) is pulled up from a silicon melt in said melt reservoir in the state that said silicon is molten in said melt reservoir to form a silicon skull layer (61) on an inner surface of said melt reservoir (60).

FIGURE 1

The present invention relates to a manufacturing method for single-crystal silicon according to Czochralski pulling method (called hereinafter CZ method).

The single-crystal silicon is an essential element for various semiconductors and highly effective solar batteries and can be obtained industrially by CZ method wherein the single-crystal silicon is pulled up from a silicon melt and Floating zone method (called hereinafter FZ method) wherein a polycrystalline silicon rod is inserted into an induction coil to create single-crystal silicon. CZ method is regarded to be economical since it requires the less number of processes and provides more profitable yield than FZ method. But, CZ method does not achieve single-crystal silicon of a quality equivalent to that obtained by FZ method due mainly to the fact that the resultant single-crystal silicon is contaminated by an impurity from a worn quartz crucible containing a silicon melt.

Also, a continuous pulling of a single-crystal silicon rod for hours is matter in CZ method since the continuous pulling may allow the single-crystal silicon rod to have a constant specific resistance in principle, thereby largely improving yield and making higher an efficiency of furnace operation. However, there has not been achieved any continuous pulling operation satisfactory to those requirements due principally to wear of the quartz crucible similarly to deterioration of the quality of single-crystal silicon.

An introduction of an electromagnetic melting process into CZ method has been recently watched with keen interest under the above circumstances. The electromagnetic melting process is a kind of floating melting method, using a circumferentially divided water-cooled conductive crucible for melting a material placed therein in a floating state through an electromagnetic field. The principle has been adopted in a polycrystalline silicon manufacturing apparatus as disclosed in Japanese Unexamined Patent Applications Nos. 52962/1986, 264920/1989 and 30698/1990 and the like. The electromagnetic melting process may be introduced into CZ method to allow a silicon melt placed in a crucible to be kept away from an inner surface of the crucible, so that there causes no wear of the crucible in principle, thereby preventing the single-crystal silicon from being polluted by an impurity from the crucible, ensuring the resultant single-crystal silicon to have quality equivalent to that obtained by FZ method and enabling a continuous pulling of the single-crystal silicon for hours.

The above technique has however many problems and has not yet been put into practical use on an industrial basis. One of the factors hindering industrialization of CZ method using the electromagnetic melting process is an agitation phenomenon of a silicon melt placed in a crucible as being kept away from its inner surface.

In detail, when an induction frequency is high in the electromagnetic melting process of silicon, current efficiency increases while skin effect is also largely developed, so that eddy current does not reach the central portion of silicon placed in a crucible, resulting in an insufficient melting at the central portion of silicon. Hence, an enlarged single-crystal silicon rod pursued now requires a lower induction frequency band width practically of 2 to 3 KHz. When the lower frequency band width is selected, current acts deeply through the surface of the melted silicon to generate an electromagnetic force through cooperation of the current and a magnetic field, thereby causing a silicon melt placed in the crucible to be subjected to an intensive agitation force. The silicon melt which is kept in a floating state in the crucible is strongly agitated to be waved on its liquid surface, thereby causing a single-crystal silicon rod pulled up from the silicon melt to have a swirl defect, dislocation and the like due to temperature fluctuation.

In addition, CZ method using the conventional electromagnetic melting process consumes almost half of applied electric power for heating the crucible, so that it is not so economical as expected in spite of that silicon is heated directly by eddy current.

An object of the present invention is to provide a manufacturing method for single-crystal silicon with a particularly higher efficiency of power consumption in comparison with the conventional CZ method using the electromagnetic melting process and without a fear of agitation in the silicon melt.

The present invention provides a manufacturing method for single-crystal silicon, characterized by providing a melt reservoir comprising an induction coil coated inside with a high-melting insulating material and adapted to apply an electromagnetic field to silicon placed in said melt reservoir to cause said silicon to heat and melt, and melting said silicon in said melt reservoir to deposit a silicon scull layer on an inner surface of said melt reservoir and pulling up a single-crystal silicon rod from a silicon melt placed in said melt reservoir.

**Brief Description of the drawings:**

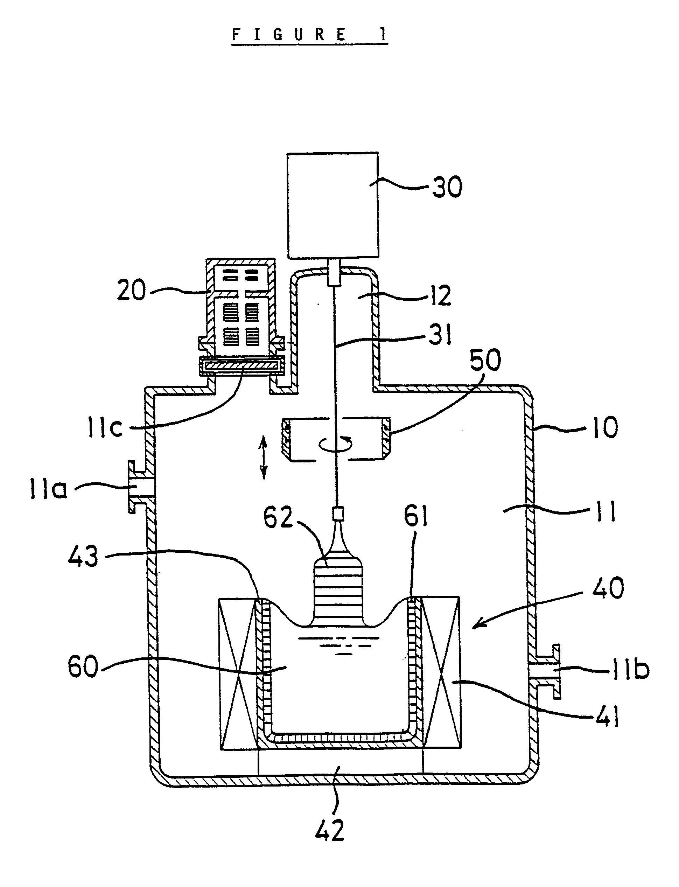

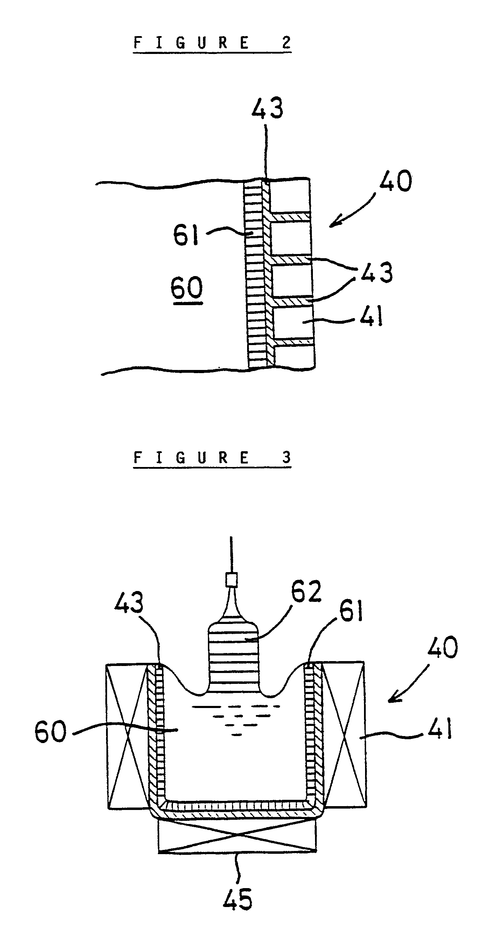

Fig. 1 is a schematic sectional view showing an apparatus suitable for a practical use of the manufacturing method according to the present invention, Fig. 2 is an enlarged sectional view showing a part of the melt reservoir and Fig. 3 is a schematic sectional view showing a modified embodiment of the melt reservoir.

The manufacturing method for a single-crystal silicon of the present invention, wherein a melt reservoir serves also as an induction coil and an electromagnetic field developed by the induction coil effects on silicon in the melt reservoir directly but not through a crucible, can improve an efficiency of electric power consumption by almost two times that in the conventional CZ method using the electromagnetic melting process.

When silicon placed in the melt reservoir serving also as the induction coil is melted, a silicon melt is brought into contact with an inner surface of the melt reservoir. Silicon as heated decreases in specific resistance and makes a good conductor in its liquid layer, so that when the silicon melt directly contacts with the induction coil, the induction coil is short-circuited. According to the manufacturing method for single-crystal silicon of the present invention, the induction coil is coated on its inner surface with an insulating material, so that the induction coil is not caused to short-circuit and the silicon melt is cooled by the melt reservoir to solidify, thereby forming a silicon scull layer over the inner surface of the melt reservoir.

The silicon scull layer protects the melt reservoir and prevents the silicon melt placed inside the silicon scull layer from being contaminated by the insulating material covered on the inner surface of the induction coil. In addition, the silicon melt placed inside the silicon scull layer adheres thereto, so that the silicon melt in the crucible even when subjected to an intensive stirring force does not have the agitation phenomenon as applied to a silicon melt when kept in a floating state. Hence, the manufacturing method for single-crystal silicon ensures high quality of a single-crystal silicon rod pulled from the silicon melt.

Next, explanation will be given on an embodiment of the present invention. Fig. 1 is a schematic sectional view showing an apparatus suitable for practical use of the manufacturing method according to the present invention.

The apparatus shown in Fig. 1 comprises an airtight casing 10 containing therein a melt reservoir 40 and a magnetic shield 50. The airtight casing 10 has a cylindrical melting chamber 11 and a pulling chamber 12 projecting upwardly and coaxially thereof. The melting chamber 11 is provided with an inactive gas introduction port 11a and an inactive gas exhaust port 11b, and at the upper part with an electron beam gun 20 having a vacuum valve 11c. A pull means 30 having a wire 31 is disposed above the pulling chamber 12.

The melt reservoir 40 is disposed axially centrally in the melting chamber 11 of the airtight casing 10 and is provided with an annular induction coil 41 and a disc-like shaped fireproofing bottom plate 42 for closing the bottom of the coil 41. An insulating layer 43 covers the inner peripheral surface of the induction coil 41 and the upper surface of the fireproofing bottom plate 42. The insulating layer 43 is made of a silicon compound of a higher melting point than silicon such as $Si_3N_4, SiO_2$ and the like and is also interposed between coils of the induction coil 41 (see Fig. 2). Thickness of the insulating layer 43 on the inner surface of the melt reservoir is preferably 0.15mm or more and not required to be more than 0.25mm.

The electron beam gun 20 is adapted to apply electron beam into the melt reservoir 40.

The magnetic shield 50 is an annular member made of water-cooled conductive materials, such as aluminum, copper and the like, or molybdenum, graphite and the like each not water-cooled and has an outer diameter slightly smaller than an inner diameter of the reservoir 40, so that the magnetic shield 50 is moved up and down in the melting chamber 11 and inserted into the melt reservoir 40 through its upper opening when required.

The manufacturing method for single-crystal silicon of the present invention may be conducted as follows by use of the above apparatus.

A material of silicon blocks or granules formed of polycrystalline silicon is placed in the melt reservoir 40 with the magnetic shield 50 being withdrawn over the reservoir. Then, the airtight casing 10 is evacuated through the exhaust port 11b to a degree of vacuum required for application of the electron beam, and the electron beam gun 20 is activated to apply electron beam to the silicon material placed in the melt reservoir 40 to cause the silicon material to be partially melted while the induction coil 41 of the reservoir 40 is excited. The induction coil 41 is properly water-cooled.

Excitation of the induction coil 41 causes an electromagnetic field to effect directly on the silicon material in the reservoir 40. The silicon material when in a solid state does not have eddy current enough to allow the silicon material to melt. Electron beam is applied to the silicon material to form therein a pool through which a sufficient eddy current flows, and the pool starts to be enlarged through self-heat evolution with Joule's heat. When a predetermined pool is formed in the silicon material, application of the electron beam is stopped.

When the silicon material in the melt reservoir 40 is melted, a silicon melt 60 is brought into contact with the inner surface of the reservoir 40. The inner surface of the induction coil 41 is covered with the insulating layer 43 to keep the silicon melt 60 from directly contacting with the induction coil 41. Hence, the induction coil 41 is not short-circuited by the silicon melt 60, and the silicon melt 60 is cooled and solidified at a portion in contact with the inner surface of the melt reservoir 40 to form a silicon scull layer 61 which is insulation and does not melt without practical Joule's heat. When required, a silicon material is supplied into the melt reservoir 40 through a hopper (not shown) provided in the airtight casing 10.

When the melt reservoir 40 is occupied with the silicon melt 60, the pull means 30 is operated to pull up with the wire 31 the silicon melt 60 which is turned and solidified in a cylindrical shape on the liquid surface to form a single-crystal silicon rod 62. At any proper stage after completion of application of the electron beam, an inactive gas such as argon and the like is introduced through the gas introduction port 11a into the airtight casing 10 to change the operation to that under atmospheric pressure.

The manufacturing method according to the present invention has the following advantages in comparison with the conventional CZ method using the electromagnetic melting process.

The melt reservoir 40 includes the induction coil 41 as an essential component, so that an electromagnetic field generated by the induction coil 41 effects directly on silicon placed in the reservoir 40. Hence, the present method improves an efficiency of power consumption by two times that of the conventional method interposing a water-cooled crucible between silicon and the induction coil.

The melt reservoir 40 is protected by the silicon scull layer 61, so that the reservoir 40 is worn substantially similarly with the conventional method keeping a silicon melt in a floating state in the water-cooled crucible.

The insulating layer 43 which serves as an inner layer of the melt reservoir 40 is formed of a silicon compound higher-melting than silicon, so that the insulating layer 43 itself is less likely to contaminate silicon. Also, the silicon scull layer 61 of the silicon melt 60 solidified which layer intervenes between the insulating layer 43 and the silicon melt 60 restrains the single-crystal silicon from being contaminated by an impurity from the melt reservoir 40 to a level of contamination equivalent to the conventional method wherein the silicon melt is kept floating in the water-cooled crucible.

The bottom and outer peripheral surfaces of the silicon melt 60 in the melt reservoir 40 adheres to the silicon scull layer 61, so that the silicon melt 60 is not agitated as conventionally by an intensive stirring force generated in a low frequency operation, whereby restraining the liquid surface of the silicon melt 60 from waving so as to largely eliminate the swirl defect, dislocation and the like of a single-crystal rod 62 obtained from the silicon melt 60 in comparison with the conventional method.

When the silicon melt 60 is stirred up to cause the liquid surface to be waved, the magnetic shield 50 is moved down into the melt reservoir 40 to approach the liquid surface of the silicon melt 60 and gradually moved down following lowering of the liquid surface as the single-crystal silicon rod 62 is pulled up, so that the liquid surface of the silicon melt 60 can be almost perfectly prevented from waving during the pulling operation of the single-crystal silicon rod 62 to further improve the quality thereof.

The present method uses application of the electron beam for the initial and partial melting of the silicon material in the melt reservoir 40 prior to an electromagnetic melting process. In the conventional method as disclosed in the aforesaid Japanese Unexamined Patent Applications Nos. 264920/1989 and 30698/1990, a high-melting conductor such as graphite, molybdenum and the like is brought into contact with silicon placed in the melting container while an electromagnetic field is excited in the container to first heat the high melting conductor and form a pool in silicon surrounding the conductor by the heat. Hence, the initial melting process of the conventional method does not prevent contamination of the single-crystal silicon rod by an impurity from the high-melting conductor. The initial melting process of the present invention using application of the electron beam can prevent the contamination with the impurity and further improve the quality of the single-crystal rod 62.

Accordingly, the manufacturing method for single-crystal silicon of the present invention provides single-crystal silicon of improved quality in comparison with the conventional CZ method using an electromagnetic melting process.

Polycrystalline silicon granules manufactured by fluidized-bed granulation process may be preferably used as a silicon material for a simple loading operation thereof.

Next, results of comparison tests conducted by the inventors will be referred to to detail the effects of the present invention.

A single-crystal silicon rod 50mm in diameter was manufactured according to CZ method with the direct melting process using the apparatus shown in Fig. 1. The initial melting process was conducted by two ways each using graphite and electron beam, respectively. The magnetic shield was not used. Table 1 shows the requirements for the magnetic melting and pulling operation. For the purpose of comparison, a single-crystal rod of the same size was manufactured according to FZ method and the conventional CZ method using an indirect melting process, respectively. The initial melting process in the latter method was conducted with graphite. Quality of the respective single-crystal silicon rods are shown in Table 2. Power consumption and wear of melt reservoirs were compared between the direct and indirect melting processes.

As seen in Table 2, the direct melting process saved the power consumption to about 40% of the indirect melting process. Also, the induction frequency which is as low as 3 KHz made the surface of the silicon melt stable and dispersion of the specific resistance uniform. Also, the initial melting process using the electron beam was adopted to cause no contamination in single-crystal silicon by carbon, thereby providing the grown single-crystal silicon with quality equivalent to the conventional FZ method.

### TABLE 1

| Requirements for electro-magnetic melting | Power frequency | 3 kHz |
| | Inner diameter of melt reservoir (Induction coil) | 150 mm |
| | Insulating material | $SiO_2$ (silicon dioxide) |
| | Thickness of insulating material | 0.2 mm |
| | Power output | 30 kw |
| | melted silicon | 5.5 kg |
| | Type of magnetic shield | Annular molybdenum member (not cooled) |
| | Diameter of magnetic shield | 142 mm |
| | Height of magnetic shield | 30 mm |
| Requirements for pulling operation | Pull velocity | 2.0 mm/min |
| | Shield rotation | 20 rpm |
| | Rotation of melt reservoir | None |
| | Diameter of single-crystal silicon rod | 50 mm |
| | Type of semiconductor | P type, ab.1Ω·cm |

## TABLE 2

| Evaluated items | Indirect melting | Direct melting | | FZ method |
|---|---|---|---|---|
| | | Graphite | Electron beam | |
| Power con- sumption | 75 kw | 30 kw | 30 kw | -- |
| Wear of re- servoir | None | None | None | -- |
| Quality — Oxygen density | less than analysis limit | less than analysis limit | less than analysis limit | less than analysis limit |
| Quality — Carbon density | $2-7 \times 10^{16}$ atoms/cc | $2-7 \times 10^{16}$ atoms/cc | $10^{16}$atoms/cc or less | $10^{16}$atoms/cc or less |
| Quality — Lifetime | 100-150µsec | 100-150µsec | 250µsec | 250µsec |
| Quality — Dispersion of specific resistance | Ununiform | Uniform | Uniform | Uniform |

In the melt reservoir 40 used in the above example, the induction coil 41 is closed at its bottom with the fireproofing bottom plate 42. The bottom plate may use an induction coil 45 as shown in Fig. 3.

In the melt reservoir 40 shown in Fig. 3, the induction coil 45 is in a configuration of a pancake as coiled in the same direction as the induction coil 41 constituting the side wall to facilitate heating of silicon placed in the reservoir 40. The induction coil 45 may be provided with an insulating layer 43 similarly with the induction coil 41.

As seen from the above, the manufacturing method for single-crystal silicon of the present invention provides such advantages that it exhibits a notably higher efficiency of power consumption, is superior in quality of the resultant single-crystal silicon and concerns no wear of the melt reservoir in comparison with the conventional CZ method using the electromagnetic melting process.

Hence, the invention can provide single-crystal silicon of high quality at a low cost, thereby largely effecting on development of a highly effective solar battery and the like.

## Claims

1. A manufacturing method for single-crystal silicon, characterized in that a melt reservoir uses induction coils coated inside with high-melting insulating material and adapted to apply an electromagnetic field to silicon placed in said melt reservoir to heat and melt said silicon, so that a single-crystal silicon rod is pulled up from a silicon melt in said melt reservoir in the state that said silicon is molten in said melt reservoir to form a silicon scull layer on an inner surface of said melt reservoir.

F I G U R E    1

FIGURE 2

FIGURE 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | GB-A-2 159 728 (WEDTECH CORP.)<br>* Claim 1; figure 1 *<br>– – – | 1 | C 30 B 15/10<br>C 30 B 15/14<br>C 30 B 29/06 |
| A | US-A-4 133 969 (A.D. ZUMBRUNNEN)<br>* Figure 3; column 8, lines 55-61; claim 1 *<br>– – – | 1 | |
| A | DE-B-1 223 351 (SIEMENS & HALSKE AG)<br>* Claims 1,4 *<br>– – – | 1 | |
| A | DE-A-2 016 101 (DOW CORNING CORP.)<br>* Claim 1; figure 1 *<br>– – – | 1 | |
| A | JOURNAL OF CRYSTAL GROWTH, vol. 50, no. 1, September 1980, pages 347-365; M.T. DUFFY et al.: "Development and evaluation of refractory CVD coatings as contact materials for molten silicon"<br>– – – | | |
| A | EP-A-0 135 676 (IBM CORP.)<br>– – – – – | | |

|  |
|---|
| TECHNICAL FIELDS SEARCHED (Int. Cl.5) |
| C 30 B |

| | | |
|---|---|---|
| The present search report has been drawn up for all claims | | |
| Place of search | Date of completion of search | Examiner |
| The Hague | 24 July 91 | GREGG N.R. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

 

& : member of the same patent family, corresponding document